Europäisches Patentamt

European Patent Office

Office européen des brevets

(11) Veröffentlichungsnummer: **0 343 563**
**A2**

(19)

## (12) EUROPÄISCHE PATENTANMELDUNG

(21) Anmeldenummer: 89109171.2

(22) Anmeldetag: 22.05.89

(51) Int. Cl.4: **H01L 29/58 , H01L 29/72**

(30) Priorität: 26.05.88 DE 3817881

(43) Veröffentlichungstag der Anmeldung:
29.11.89 Patentblatt 89/48

(84) Benannte Vertragsstaaten:
DE FR GB IT

(71) Anmelder: **Siemens Aktiengesellschaft**
**Wittelsbacherplatz 2**
**D-8000 München 2(DE)**

(72) Erfinder: **Kabza, Herbert, Dr.**
**Eschenrieder Strasse 13/B**
**D-8000 München 60(DE)**
Erfinder: **Probst, Volker**
**Ehrengutstrasse 15**
**D-8000 München 5(DE)**
Erfinder: **Schaber, Hans-Christian, Dr.**
**Kreuzlinger Strasse 72**
**D-8034 Unterpfaffenhofen(DE)**

(54) Bipolartransistorstruktur mit reduziertem Basiswiderstand und Verfahren zur Herstellung eines Basisanschlussbereiches für eine Bipolartransistorstruktur.

(57) Zur Verringerung des Basiswiderstandes in der Bipolartransistorstruktur wird der Basisanschlußbereich als Mehrschichtstruktur ausgebildet. Die Mehrschichtstruktur enthält eine dotierte Polysiliziumschicht (3), eine elektrisch leitende Diffusionsbarriereschicht (4), die eine Aufwärtsdiffusion der Dotierstoffe aus der Polysiliziumschicht (3) und damit eine Dotierstoffverarmung der Polysiliziumschicht (3) verhindert, eine Metallsilizidschicht (5) und eine $SiO_2$-Schicht (6). Die Polysilizium- (3), die Diffusionsbarrieren- (4) und die Metallsilizidschicht (5) weisen gemeinsame vertikale Ätzprofile auf.

## FIG 1

EP 0 343 563 A2

## Bipolartransistorstruktur mit reduziertem Basiswiderstand und Verfahren zur Herstellung eines Basisanschlußbereiches für eine Bipolartransistorstruktur

Die Erfindung betrifft eine Bipolartransistorstruktur mit einem n-dotierten Kollektorbereich und einem Kollektoranschlußbereich, mit selbstjustierten Emitter-Basisbereichen, wobei der n-dotierte Emitterbereich zentral im p-dotierten Basisbereich vorgesehen ist, so daß unter dem Emitterbereich eine aktive Basiszone und ringförmig dazu eine inaktive Basiszone angeordnet sind, mit aus dotierten Polysiliziumschichten bestehenden, direkt auf dem Substrat oberhalb der inaktiven Basiszone, der Emitterzone und den Kollektoranschlußbereich angeordneten Strukturen, die die Anschlüsse bilden, mit Metallsilizidstrukturen oberhalb der Polysiliziumstrukturen zur Kontaktierung der Basis, mit $SiO_2$-Schichten als Maskierungs- und Isolationsschichten und mit vertikalen Ätzprofilen in den $SiO_2$-, Polysilizium- und Metallsilizidschichten, sowie ein Verfahren zum Herstellen eines Basisanschlußbereiches für eine Bipolartransistorstruktur.

In vielen Anwendungen bipolarer Transistoren wird unter anderem ein geringer Basiswiderstand angestrebt.

Ein Bipolartransistor mit reduziertem Basiswiderstand ist zum Beispiel aus der europäischen Patentanmeldung 0 226 890 bekannt. Die Reduktion des Basiswiderstands wird hier dadurch erzielt, daß auf die den Basisanschluß bildende Polysiliziumstruktur nach der Herstellung des Emitteranschlusses und nach der Erzeugung der zugehörigen Flankenisolationsschicht eine elektrisch leitfähige Schicht aufgebracht wird, die aus einem Silizid eines hochschmelzenden Metalls oder aus einem hochschmelzenden Metall selbst besteht. Die elektrisch leitfähige Schicht umschließt den Emitteranschluß ringförmig. Da die elektrisch leitfähige Schicht erst nach der Herstellung des Emitteranschlusses und der Erzeugung der zugehörigen Flankenisolationsschicht auf die den Basisanschluß bildende Polysiliziumstruktur aufgebracht wird, überdeckt die elektrisch leitfähige Schicht nicht die gesamte Oberfläche der Polysiliziumstruktur, die den Basisanschlußbereich bildet. Eine vollständige Überdeckung der Oberfläche, die zu einer weiteren Reduktion des Basiswiderstandes führen würde, ist hier nicht möglich, da die notwendige Überdeckung des $p^+$-Polysiliziums für den Basisanschluß durch das $n^+$-Polysilizium für den Emitteranschluß, das bei dem selbstjustierten Aufbringen der elektrisch leitfähigen Schicht als Maske verwendet wird, schon einen Teil der Oberfläche der den Basisanschlußbereich bildenden Polysiliziumstruktur bedeckt.

Der Erfindung liegt die Aufgabe zugrunde, eine Bipolartransistorstruktur, die einen Basisanschlußbereich mit weiter reduziertem Basiswiderstand aufweist, sowie ein Verfahren zum Herstellen des Basisanschlußbereiches anzugeben.

Die Aufgabe wird durch eine Bipolartransistorstruktur der eingangs genannten Art erfindungsgemäß durch folgende Merkmale gelöst:

a) der Basisanschluß ist als Mehrschichtstruktur ausgebildet, die die Polysilizium, die Metallsilizid- und eine $SiO_2$-Schicht enthält, wobei zwischen der Polysilizium- und der Metallsilizidschicht eine Diffusionsbarriereschicht und auf der Metallsilizidschicht die $SiO_2$-Schicht angeordnet ist,

b) die Diffusionsbarriereschicht besteht aus einem elektrisch leitfähigen Material, in dem eine Aufwärtsdiffusion des p-Dotierstoffes aus der Polysiliziumschicht unmöglich ist, wodurch eine p-Dotierstoffverarmung der Polysiliziumschicht vermieden wird,

c) die Polysilizium-, Diffusionsbarrieren- und Metallsilizidschicht weisen gemeinsame vertikale Ätzprofile auf, deren Flanken mit einer $SiO_2$-Schicht bedeckt sind.

Die Aufgabe wird ferner durch ein Verfahren zum Herstellen eines Basisanschlußbereiches für eine erfindungsgemäße Bipolartransistorstruktur gelöst, das durch folgende Schritte gekennzeichnet ist:

a) nach der ganzflächigen Erzeugung einer $p^+$-leitenden ersten Polysiliziumschicht auf einem Siliziumsubstrat wird auf die erste Polysiliziumschicht ganzflächig eine elektrisch leitende Diffusionsbarriereschicht aufgebracht, die die Dotierstoffdiffusion aus der ersten Polysiliziumschicht nach oben verhindert,

b) auf die Diffusionsbarriereschicht wird ganzflächig eine Metallsilizidschicht aufgebracht,

c) auf die Metallsilizidschicht wird ganzflächig eine Oxidschicht aufgebracht,

d) nach einer Fotolacktechnik werden die erste Polysiliziumschicht, die Diffusionsbarriereschicht, die Metallsilizidschicht und die Oxidschicht durch eine Abfolge von vertikale Ätzprofile erzeugenden Trockenätzverfahren so strukturiert, daß sie eine gemeinsame vertikale Flanke aufweisen und der Basisbereich definiert wird.

In bekannter Weise wird in einem späteren Schritt der Transistorherstellung der inaktive Basisbereich durch Eindiffundieren der in der Polysiliziumschicht enthaltenen p-Dotierstoffe gebildet und dabei mit der aktiven Basis verbunden. Hierbei verhindert die Diffusionsbarriereschicht eine Aufwärtsdiffusion der p-Dotierstoffe in Richtung $SiO_2$-

Schicht.

Eine solche Segregation der Dotierstoffe, d.h. eine Diffusion von in einer Polysiliziumschicht enthaltenen Dotierstoffe durch eine darüber liegende Metallsilizidschicht an die Grenzfläche zu einer $SiO_2$-Schicht, spielt eine große Rolle in Bor-dotierten Polysiliziumschichten mit darüber angeordneten $TaSi_2$-Schichten. Durch die Verwendung einer Titannitrid-Diffusionsbarriereschicht wird hier eine Bor-Segregation vermieden.

Ferner findet eine Dotierstoffverarmung von Bor-dotierten Polysiliziumschichten mit darüber angeordneten Metallsilizidschichten durch die Bildung von Metall-Bor-Verbindungen statt. Diese Reaktion wird bei Anwesenheit von Sauerstoff verstärkt. Dieser Effekt tritt besonders bei der Verwendung von Metallsilizidschichten aus Tantalsilizid, Titansilizid, Kobaltsilizid und Wolframsilizid auf.

Bei Nichtverwendung einer Diffusionsbarriereschicht kommt es zu einer Dotierstoffverarmung in der Polysiliziumschicht, so daß die inaktive Basis nicht in ausreichender Ausdehnung gebildet werden kann und es daher nicht zu der nötigen Verbindung zwischen der inaktiven und der aktiven Basis kommen kann.

Dieser gravierende Nachteil, der bei einer aus einer dotierten Polysilizium- und einer Metallsilizidschicht bestehenden sogenannten Polyzidschicht als Basisanschluß auftritt, wird im Stand der Technik dadurch vermieden, daß die Metallsilizidschicht erst nach der Formierung des Emitters aus der Emitter-Polysiliziumschicht und der Bildung der inaktiven Basis auf die Polysiliziumschicht aufgebracht wird.

Die Erfindung vermeidet diesen Nachteil dadurch, daß in der den Basisanschluß bildenden Mehrschichtstruktur die dotierte Polysiliziumschicht durch die Diffusionsbarriere von der Metallsilizidschicht getrennt ist. Die Mehrschichtstruktur wird daher schon vor der Bildung der inaktiven Basis aufgebracht.

Gegenüber dem Stand der Technik hat die Erfindung daher den Vorteil, daß die gesamte Oberfläche der Polysiliziumschicht mit der Metallsilizidschicht bedeckt ist. Dadurch wird eine deutliche Reduktion des Basiswiderstands erzielt.

Weitere Ausgestaltungen der Erfindung gehen aus den Unteransprüchen hervor.

Anhand von Ausführungsbeispielen, die in den Figuren dargestellt sind, wird die Erfindung im folgenden näher erläutert.

Fig. 1 zeigt einen Ausschnitt aus einem Bipolartransistor, der den Basisanschlußbereich enthält.

Fig. 2 und 3 zeigen Schritte in der Herstellung des erfindungsgemäßen Basisanschlußbereiches.

Fig. 4 zeigt eine in einem Substrat enthaltene Bipolartransistorstruktur, die erfindungsgemäße Basisanschlußbereiche enthält.

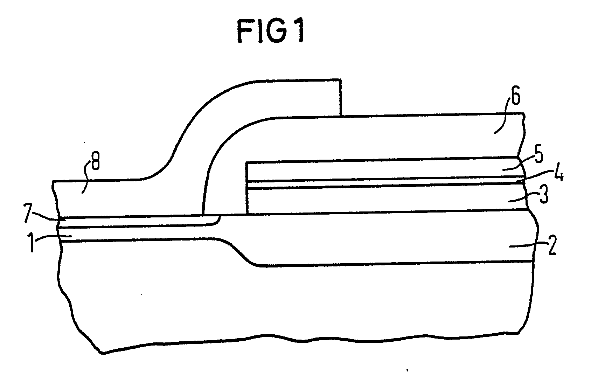

In Fig. 1 ist ein Ausschnitt eines Bipolartransistors dargestellt. Der Ausschnitt enthält eine aktive Basis 1 und eine inaktive Basis 2. Die Gebiete der aktiven Basis 1 und der inaktiven Basis 2 sind so dotiert, daß sie p-leitend sind, z.B. durch Dotierung mit Bor. Oberhalb der aktiven Basis 1 liegt ein Emitter 7. Oberhalb der inaktiven Basis 2 ist der Basisanschlußbereich angeordnet, der eine erste Polysiliziumschicht 3, eine Diffusionsbarriereschicht 4 und eine Metallsilizidschicht 5 umfaßt. Die erste Polysiliziumschicht 3 ist p-dotiert, z.B. durch Dotierung mit Bor. Die Diffusionsbarriereschicht 4 ist elektrisch leitfähig und hat die Eigenschaft, eine Dotierstoffdiffusion aus der ersten Polysiliziumschicht 3 nach oben zu verhindern. Die Diffusionsbarriereschicht 4 besteht z.B. aus Titannitrid (TiN). Sie hat eine Dicke von mindestens etwa 20 nm. Die Metallsilizidschicht 5 besteht z.B. aus $TaSi_2$. Auf die Metallsilizidschicht 5 des Basisanschlußbereichs folgt eine Isolationsschicht 6. Die Isolationsschicht 6 besteht z.B. aus $SiO_2$ und ist so ausgebildet, daß sie die Flanken der aus der ersten Polysiliziumschicht 3, der Diffusionsbarriereschicht 4 und der Metallsilizidschicht 5 gebildeten Mehrschichtstruktur bedeckt. Oberhalb des Emitters 7 ist eine zweite Polysiliziumschicht 8 angeordnet. Die zweite Polysiliziumschicht 8 ist n-dotiert, sie wirkt als Dotierstoffquelle für die Emitterdiffusion und als Emitteranschluß. Da die Isolationsschicht 6 die zweite Polysiliziumschicht 8 von der den Basisanschluß bildenden Mehrschichtstruktur trennt, erfolgt die Bildung des aktiven Emitters 7 durch Eindiffusion selbstjustiert zur aktiven Basis 1 und zur inaktiven Basis 2.

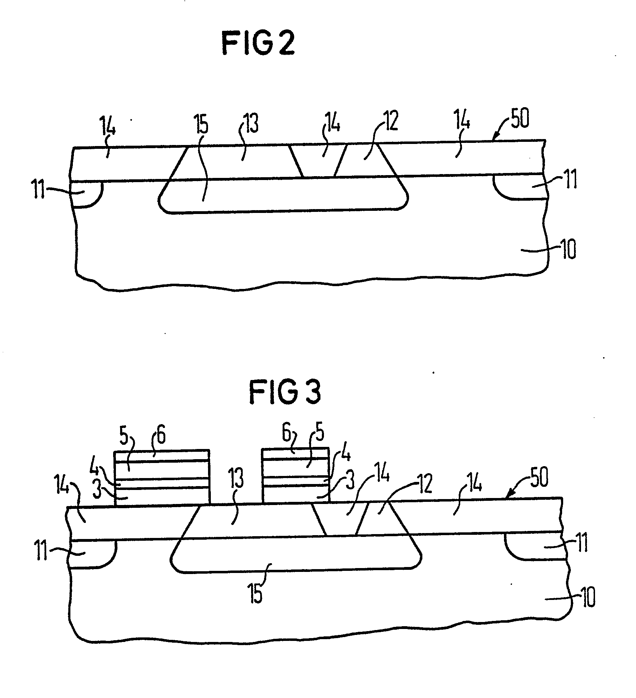

Anhand von Fig. 2 und Fig. 3 wird im folgenden das Verfahren zur Herstellung des Basisanschlußbereichs für eine Bipolartransistorstruktur geschildert. Die in Fig. 2 dargestellte Anordnung wird durch folgende, aus dem Stand der Technik bekannte (siehe z.B. europäische Patentanmeldung 0 226 890) Verfahrensschritte erzeugt:

In einem p-dotierten Siliziumsubstrat 10 wird ein vergrabener Kollektorbereich 15 durch maskierte Ionenimplantation von Antimon oder Arsen gebildet. Auf der den vergrabenen Kollektorbereich 15 enthaltenen Oberfläche des Siliziumsubstrats 10 wird eine $n^-$-dotierte Epitaxieschicht 13 abgeschieden. In dem Siliziumsubstrat 10 werden durch Borionenimplantation oder -diffusion channel stopper-Bereiche 11 erzeugt. Die channel stopper-Bereiche 11 haben die Funktion, benachbarte Kollektorgebiete im Siliziumsubstrat 10 sicher zu isolieren und parasitäre Dickoxidtransistoren zu vermeiden. Auf die Epitaxieoberfläche 13 wird eine aus Siliziumoxid und Siliziumnitrid bestehende Doppelschicht aufgebracht und für den nachfolgenden LOCOS-Schritt oder ähnliches durch entsprechende Strukturierung der Siliziumnitridschicht vorbereitet. Unter Verwendung der so erzeugten Siliziumnitridstruktur als Oxidationsmaske werden Feldoxidbereiche 14 hergestellt, die für die Trennung der aktiven Transistorbereiche erforderlich sind. Im folgenden wird die Nitrid/Oxidmaskierung entfernt. Nach einer Fotolacktechnik werden Kollektoranschlußbereiche 12 durch Implantation oder Diffusion von Phosphoratomen hergestellt. In einem Hochtemperaturschritt bei $900^{\circ}$ bis $1100^{\circ}$ wird der Kollektoranschlußbereich 12 bis zum vergrabenen Kollektorbereich 15 eingetrieben.

Auf die so entstandene, aus dem Kollektoranschlußbereich 12, der $n^{-}$-dotierten Epitaxieschicht 13 und den Feldoxidbereichen 14 bestehenden Oberfläche 50 wird die erste Polysiliziumschicht 3 aufgebracht (siehe Fig. 3). Die erste Polysiliziumschicht 3 wird ganzflächig aufgebracht. Darauf folgt eine Borimplantation in die erste Polysiliziumschicht 3, so daß diese $p^{+}$-leitend wird. Eine andere, im Ergebnis gleichwertige Möglichkeit besteht darin, die erste Polysiliziumschicht 3 dotiert abzuscheiden.

Die dotierte Abscheidung hat gegenüber der Dotierung durch Implantation den Vorteil, daß ein Verfahrensschritt eingespart wird. Die Dotierung der ersten Polysiliziumschicht 3 durch Implantation hat ferner den Nachteil, daß die Implantation wegen der geringen Schichtdicke der ersten Polysiliziumschicht 3 bei niedriger Energie erfolgen muß. Bei niedriger Energie werden die Implantationsstrahlstromstärken sehr gering. Daher ist dieses Verfahren zeitaufwendig.

Auf die erste Polysiliziumschicht 3 wird die Diffusionsbarriereschicht 4 aufgebracht. Die Diffusionsbarriereschicht 4 ist elektrisch leitend und besteht zum Beispiel aus Titannitrid. Die Diffusionsbarriereschicht 4 hat die Eigenschaft, eine Diffusion des in der ersten Polysiliziumschicht 3 enthaltenen Dotierstoffes aus der ersten Polysiliziumschicht 3 nach oben zu verhindern. Auf die Diffusionsbarriereschicht 4 wird wiederum ganzflächig die Metallsilizidschicht 5 aufgebracht. Die Metallsilizidschicht 5 besteht z.B. aus $TaSi_2$. Auf die Metallsilizidschicht 5 wird die Isolationsschicht 6 aufgebracht.

Nach einer Fototechnik wird die Isolationsschicht 6, die Metallsilizidschicht 5, die Diffusionsbarriereschicht 4 und die erste Polysiliziumschicht 3 in mehreren Schritten mit anisotroper Trockenätzung strukturiert (siehe Fig. 3). Diese Strukturierung erfolgt so, daß die erste Polysiliziumschicht 3 die Diffusionsbarriereschicht 4, die Metallsilizidschicht 5 und die Islationsschicht 6 gemeinsame vertikale Flanken aufweisen und daß die Oberfläche 50 außerhalb der so entstehenden Mehrschichtstruktur freigelegt wird. Auf diese Weise werden mit nur einer Fototechnik sowohl der aktive Transistorbereich bestehend aus Emitter 7 und aktiver Basis 1 als auch die inaktive Basis 2 und deren Anschluß durch die Mehrfachstruktur bestehend aus der ersten Polysiliziumschicht 3, der Diffusionsbarriereschicht 4 und der Metallsilizidschicht 5 definiert.

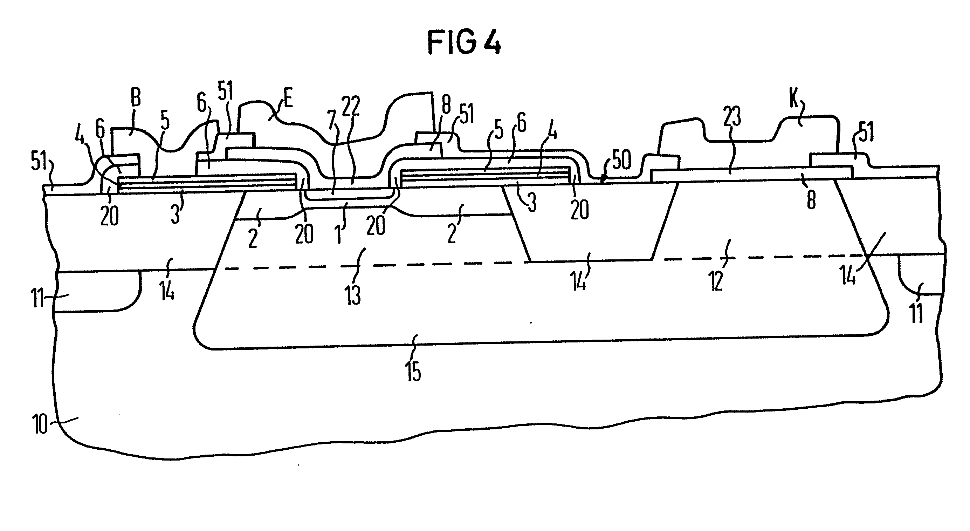

Fig. 4 zeigt eine Bipolartransistorstruktur, die aus der in Fig. 3 dargestellten Struktur durch folgende, aus dem Stand der Technik (siehe z.B. europäische Patentanmeldung 0 226 890) bekannte Schritte gewonnen wird:

Auf dem Siliziumsubstrat 10, das die channel stopper-Bereiche 11, den Kollektoranschlußbereich 12, die $n^{-}$-dotierte Epitaxieschicht 13, die Feldoxidbereiche 14 und den vergrabenen Kollektorbereich 15 enthält und das mit der den Basisanschlußbereich definierenden Mehrschichtstruktur, die aus der ersten Polysiliziumschicht 3, der Diffusionsbarriereschicht 4, der Metallsilizidschicht 5 und der Isolationsschicht 6 besteht, versehen ist, werden Flankenisolationsschichten 20 erzeugt, die die Flanken der Mehrschichtstruktur ganz bedecken. Die Flankenisolationsschichten 20 bestehen z.B. aus $SiO_2$. Dann wird ganzflächig die zweite Polysiliziumschicht 8 abgeschieden. Falls die zweite Polysiliziumschicht 8 nicht n-dotiert abgeschieden wurde, folgt ein Implantationsschritt. Nach einer Fotolacktechnik wird die zweite Polysiliziumschicht 8 so strukturiert, daß der Emitteranschlußbereich 22 und der Kollektoranschlußbereich 23 definiert werden.

Nach Abscheidung einer weiteren Isolationsschicht 51, z.B. aus $SiO_2$, werden in einem Diffusionsschritt der aktive Emitter 7 und die inaktive Basis 2 gemeinsam ausgetrieben. Mit Hilfe einer weiteren Fototechnik werden die Kontaktflächen für den Emitteranschluß E und den Kollektoranschluß K in der weiteren Isolationsschicht 51 und für den Basisanschluß B in der weiteren Isolationsschicht 51 und in der Isolationsschicht 6 geöffnet. Die Lage der Kontaktlöcher wird an die Anschlußbedingungen der jeweiligen Schaltung angepaßt.

Die Metallisierung der Kontaktlöcher erfolgt nach Standardprozeßschritten.

Eine Möglichkeit, auch den Kontaktwiderstand für den Emitteranschluß E und den Kollektoranschluß K zu verringern, besteht darin, nach der Strukturierung der zweiten Polysiliziumschicht 8 eine Prozeßsequenz zur Erzeugung selbstjustierter Silizidschichten auf diesen $n^{+}$-Polysiliziumstrukturen einzuführen. Der weitere Prozeßablauf entspricht dem oben geschilderten.

## Ansprüche

1. Bipolartransistorstruktur -mit einem, n-dotierten Kollektorbereich und einem Kollektoranschlußbereich,
-mit selbstjustierten Emitter-Basisbereichen, wobei der n-dotierte Emitterbereich zentral im p-dotierten Basisbereich vorgesehen ist, so daß unter dem Emitterbereich eine aktive Basiszone und ringförmig dazu eine inaktive Basiszone angeordnet sind,
-mit aus dotierten Polysiliziumschichten bestehenden, direkt auf dem Substrat oberhalb der inaktiven Basiszone, der Emitterzone und dem Kollektoranschlußbereich angeordneten Strukturen, die die Anschlüsse bilden,
-mit Metallsilizidstrukturen oberhalb der Polysiliziumstrukturen zur Kontaktierung der Basis,
-mit $SiO_2$-Schichten als Maskierungs-und Isolationsschichten und -mit vertikalen Ätzprofilen in den $SiO_2$-, Polysilizium- und Metallsilizidschichten, **gekennzeichnet** durch folgende Merkmale:

a) der Basisanschluß ist als Mehrschichtstruktur ausgebildet, die die Polysilizium- (3), die Metallsilizid- (5) und eine $SiO_2$-Schicht (6) enthält, wobei zwischen der Polysilizium- (3) und der Metallsilizidschicht (5) eine Diffusionsbarriereschicht (4) und auf der Metallsilizidschicht (5) die $SiO_2$-Schicht (6) angeordnet ist,

b) die Diffusionsbarriereschicht (4) besteht aus einem elektrisch leitfähigen Material, in dem eine Aufwärtsdiffusion des p-Dotierstoffes aus der Polysiliziumschicht (3) unmöglich ist, wodurch eine p-Dotierstoffverarmung der Polysiliziumschicht (3) vermieden wird,

c) die Polysilizium- (3), Diffusionsbarrieren- (4) und Metallsilizidschicht (5) weisen gemeinsame vertikale Ätzprofile auf, deren Flanken mit einer $SiO_2$-Schicht (6, 20) bedeckt sind.

2. Bipolartransistorstruktur nach Anspruch 1, dadurch **gekennzeichnet,** daß der Dotierstoff in der Polysiliziumschicht (3) Bor ist und daß die Diffusionsbarriereschicht (4) aus Titannitrid besteht.

3. Bipolartransistorstruktur nach Anspruch 1 oder 2, dadurch **gekennzeichnet,** daß die Metallsilizidschicht aus Tantalsilizid besteht.

4. Verfahren zum Herstellen eines Basisanschlußbereiches für eine Bipolartransistorstruktur nach einem der Ansprüche 1 bis 3 **gekennzeichnet** durch folgende Schritte:

a) nach der ganzflächigen Erzeugung einer $p^{\pm}$ leitenden ersten Polysiliziumschicht (3) auf einem Siliziumsubstrat (10) wird auf die erste Polysiliziumschicht (3) ganzflächig eine elektrisch leitende Diffusionsbarriereschicht (4) aufgebracht, die die Dotierstoffdiffusion aus der ersten Polysiliziumschicht (3) nach oben verhindert,

b) auf die Diffusionsbarriereschicht (4) wird ganzflächig eine Metallsilizidschicht (5) aufgebracht,

c) auf die Metallsilizidschicht (5) wird ganzflächig eine Oxidschicht (6) aufgebracht,

d) nach einer Fotolacktechnik werden die erste Polysiliziumschicht (3), die Diffusionsbarriereschicht (4), die Metallsilizidschicht (5) und die Oxidschicht (6) durch eine Abfolge von vertikale Ätzprofile erzeugenden Trockenätzverfahren so strukturiert, daß sie eine gemeinsame vertikale Flanke aufweisen und der Basisbereich definiert wird.

5. Verfahren nach Anspruch 4, dadurch **gekennzeichnet,** daß die $p^{+}$-leitende erste Polysiliziumschicht (3) durch dotierte Abscheidung erzeugt wird.

# FIG 1

# FIG 2

# FIG 3

# FIG 4

EP 0 343 563 A2